# EUROPEAN PATENT SPECIFICATION

(11) **EP 2 302 681 B1**
(45) Date of publication and mention of the grant of the patent: **26.04.2017**
(21) Application number: 10003084.0
(22) Date of filing: 23.03.2010
(51) Int. Cl.: H01L 27/146, H01L 21/20, H01L 21/02, H01L 31/0352, H01L 31/18

(54) **IMPROVED SEMICONDUCTOR SENSOR STRUCTURES WITH REDUCED DISLOCATION DEFECT DENSITIES**
VERBESSERTE HALBLEITERSENSORSTRUKTUREN MIT VERRINGERTEN VERSETZUNGSDEFEKTDICHTEN
STRUCTURES DE CAPTEUR A SEMI-CONDUCTEUR AMELIOREES AVEC DENSITES DE DEFAUT DE DISCLOCATION REDUITS

(30) Priority: 24.09.2009 US 565863
(43) Date of publication of application: 30.03.2011
(73) Proprietor: Taiwan Semiconductor Manufacturing Co., Ltd., Hsin-Chu, 300-77 (TW)
(72) Inventor: Cheng, Zhi-Yuan, Lincoln, MA 01773 (US); Fiorenza, James G., Wilmington, MA 01887 (US); Sheen, Calvin, Derry, NH 03038 (US); Lochtefeld, Anthony J., Ipswich, MA 01938 (US)
(74) Representative: Ter Meer Steinmeister & Partner

(56) References cited:
- WO-A2-2006/125040
- US-A1- 2004 121 507
- US-A1- 2007 181 977
- US-A1- 2007 187 796
- US-A1- 2009 065 047

## Description

### TECHNICAL FIELD OF THE DISCLOSURE

The technical field of this disclosure relates to the art of semiconductor sensor devices.

### BACKGROUND OF THE DISCLOSURE

There is a constant drive within the semiconductor industry to increase the performance and reduce the cost of semiconductor devices, such as photodetectors, diodes, light-emitting diodes, transistors, latches, and many other semiconductor devices. This drive has resulted in continual demands for integrating one type of semiconductor devices into another semiconductor process.

For example in photodetectors that are comprised of an array of ***p-n*** junctions or **p-i-n** structures, it is advantages to make the ***p-n*** junctions and/or **p-i-n** structures with low band-gap materials, such as germanium (Ge) and InGaAs, because the photodetectors are able to detect infrared light. In favor of the cost-efficiency, it is desired to produce a thin film of III-V or other non-silicon materials on low-cost large-size silicon wafers to reduce the cost of high performance III-V devices. It is further desired to integrate non-silicon ***p-n*** junctions and/or **p-i-n** structures (e.g. Ge or InGaAs based) into a silicon process such that other circuitry in a systems, such as a photodetector, can be fabricated using a standard silicon process, such as a standard CMOS (complementary-metal-oxide-semiconductor) process. It is also desirable to fabricate the non-silicon devices and silicon CMOS in a co-planar manner, so that the interconnection and integration of the whole system can be conducted in a manner compatible with standard and low-cost CMOS process. Further, it is desirable to increase a size of non-silicon regions configured to output electrons generated by light absorption therein.

US 2009/0065047 A1 is concerned with multi-junction solar cells and discloses a solar cell architecture comprising a substrate and SiO₂ side walls provided thereon to form trenches. A film is grown in the trenches until it overflows the trenches to create a single continuous film, i.e. an ART buffer layer. A solar cell p-n junction is then grown on the whole buffer layer. The solar cell p-n junction includes a base and an emitter with a metal disclosed thereon. The metal layer forms a contact.

US 2004/0121507 A1 is concerned with semiconductor devices with reduced active region defects and unique contacting schemes, and discloses a semiconductor device comprising a single crystal substrate of a first material and a cladding layer of a dielectric material formed thereon. Embedded in the cladding layer is a pair single crystal regions, i.e. a stem region in contact with the single crystal substrate through an opening in the cladding layer and an active region formed on the stem region. The active region is essentially defect free. Contacts are provided in contact with p-type and n-type regions of the active region.

WO 2006/125040 A2 is concerned with a lattice-mismatched semiconductor structures with reduced dislocation defect densities and discloses a method of forming a regrowth layer wherein a substrate is provided with a dislocation-blocking mask having trenches, openings or the like formed therein. A layer is formed in the openings of the mask by an ART process. When the top of the mask is reached a regrowth layer in the opening becomes an overgrowth layer extending to the lateral sites by lateral epitaxial overgrowth.

US 2007/0181977 A1 discloses a method of forming areas of alternative materials on crystalline semiconductor substrates. In particular, an opening in a substrate is filled with an active area material by epitaxial growth.

### BRIEF DESCRIPTION OF DRAWINGS

FIG. 1a through FIG. 1d diagrammatically illustrate an exemplary method of making a semiconductor device;
FIG. 2 diagrammatically illustrates a cross-sectional view of an exemplary structure having an epitaxial-lateral-overgrowth at or in which a semiconductor device can be fabricated;
FIG. 3 diagrammatically illustrates a cross-sectional view of an exemplary structure having a large lateral intrinsic region;
FIG. 4 diagrammatically illustrates a top view of an exemplary layout of multiple trenches in a substrate capable for growing epitaxial crystalline materials;
FIG. 5 diagrammatically illustrates an exemplary structure having non-silicon semiconductor devices integrated in a silicon process;
FIG. 6 diagrammatically illustrates an exemplary structure having a ***p-i-n*** structure formed in a shallow-trench-insulator region;
FIG. 7 diagrammatically illustrates another exemplary structure having a ***p-i-n*** structure formed in a shallow-trench-insulator region;
FIG. 8 is a diagram of a portion of an exemplary array of photodetectors;
FIG. 9 diagrammatically illustrates an energy-band structure of a ***p-i-n*** structure at zero bias voltage;
FIG. 10 diagrammatically illustrates the energy-band structure of the ***p-i-n*** structure in FIG. 9 at a bias voltage;
FIG. 11 is a diagram showing a portion of the array of photodetectors in FIG. 8;
FIG. 12 diagrammatically illustrates an exemplary configuration of the transistors in the photodetector array in FIG. 8;
FIG. 13 diagrammatically illustrates another exemplary configuration of the transistors in the photodetector array in FIG. 8;
FIG. 14 diagrammatically illustrates an exemplary configuration of the ***p-i-n*** structure connected to a transistor in the photodetector array in FIG. 8;
FIG. 15 diagrammatically illustrates a cross-sectional view of an exemplary semiconductor device formed at or in a coalesced region formed by adjacent ART (aspect-ratio-trapping) structures;
FIG. 16 diagrammatically illustrates a cross-sectional view of another exemplary semiconductor device formed at or in a coalesced region formed by adjacent ART (aspect-ratio-trapping) structures;
FIG. 17 diagrammatically illustrates a cross-sectional view of an exemplary structure having a semiconductor device formed on a graded buffer layer in an opening of a dielectric layer;
FIG. 18 diagrammatically illustrates a cross-sectional view of an exemplary structure having a semiconductor device formed on a graded buffer layer in a trench formed in a crystalline substrate;
FIG. 19a diagrammatically illustrates a cross-sectional view of a portion of an exemplary array of non-silicon photodetectors integrated in a silicon substrate, wherein the photodetector is capable of detecting light incident thereto from the top;
FIG. 19b diagrammatically illustrates a top view of a portion of the photodetectors in FIG. 19a;
FIG. 20a diagrammatically illustrates a cross-sectional view of a portion of an exemplary array of non-silicon photodetectors integrated in a silicon substrate, wherein the photodetector is capable of detecting light incident thereto from the side;
FIG. 20b diagrammatically illustrates a top view of a portion of the photodetectors in FIG. 20a;
FIG. 21a and FIG. 21b diagrammatically illustrate an exemplary configuration of electrical connections of photodetectors to electrical contacts; and
FIG. 22 is a cross-section of an exemplary semiconductor device having a non-isolated defect region.

### DETAILED DESCRIPTION OF SELECTED EXAMPLES

Disclosed herein is a method of making semiconductor devices and semiconductor devices made thereof.

The method enables integration of non-silicon semiconductor devices into a silicon process such that silicon circuitry of the semiconductor device can be formed through standard silicon processes. This integration capability can be of great importance in using low band-width or high band-width semiconductor materials for making semiconductor device having ***p-n*** and *p-i-n* structures in silicon processes.

The method also enables forming ART (aspect-ratio-trapping) crystalline structures in a trench structure, such as a trench structure patterned by a trench patterning-process *(e.g.* a standard complementary-metal-oxide-semiconductor (CMOS) STI (shallow-trench-insulation) process) or a STI-like trench patterned structure. The semiconductor devices formed at or in the ART structure(s) can have any desired lateral and/or vertical dimensions that are substantially free from the aspect-ratio requirements or process limitations in most current ART techniques. For demonstration and simplicity purposes, the method will be discussed with reference to selected examples wherein ART crystalline structures are formed on STI process trench structures in some of the examples. It will be appreciated by those skilled in the art that the exemplary methods as discussed in the following can also be implemented to form ART structures on other types of trenches.

Aspect Ratio Trapping (ART) is a defect reduction and heteroepitaxy growth technique. As used herein, "ART" or "aspect ratio trapping" refers generally to the technique(s) of causing defects to terminate at non-crystalline, *e.g.*, dielectric sidewalls during heteroepitaxy growth, where the sidewalls are sufficiently high relative to the size of the growth area so as to trap most, if not all, of the defects. ART utilizes high aspect ratio openings, such as trenches or holes, to trap dislocations, preventing them from reaching the epitaxial film surface, and greatly reduces the surface dislocation density within the ART opening. Further details of example ART devices and ART techniques are described in US2006 292719 A1, US2007 181977 A1 and US2008 099785 A1.

Furthermore, with customized ART growth parameters, an enhanced lateral epitaxy overgrowth (ELO) mode may be realized for expanded epitaxy beyond the trenched region, e.g., regions with openings formed therein, which yields bulky "free-standing" high quality materials centered above the initial trenched seed layer. Therefore, a combined ART and ELO technology greatly increases the quality and applicable film surface area of lattice-mismatched materials on substrates such as Si substrates. The relatively simple process enables reliable and reproducible results.

The method further enables forming a large-scale ART structure in the presence of STI process trenches, which in turn enables forming a semiconductor device or an element of a semiconductor device with desired lateral or vertical dimension. In particular, a large-scale intrinsic semiconductor region can be formed in the large-scale ART structure.

The method enables forming a semiconductor device or an element of a semiconductor device on a buffer layer disposed on a semiconductor crystalline substrate, whereas the buffer layer can be graded. The buffer layer can be disposed within an opening formed in a dielectric layer or can be disposed in a trench formed in a crystalline substrate.

The method also enables forming anisotropic or isotropic ELO (epitaxial-lateral-overgrown) regions, at or in which a semiconductor element or a semiconductor device can be formed.

The method also enables forming semiconductor devices or elements of semiconductor devices in coalesced regions between adjacent ART structures.

The method also enables forming lateral ***p-n*** and *p-i-n* structures of semiconductor devices at or in an ART structure.

In a particular implementation, the method is capable of being used for making a semiconductor device having complementary-metal-oxide-semiconductor device with a photodetector that is formed at or in an ART structure. Other non-silicon or silicon based circuitry can also be formed along with the photodetector.

The method and semiconductor devices made thereof will be discussed in the following with selected examples. It will be appreciated by those skilled in the art that the following discussion is for demonstration purposes and should not be interpreted as a limitation. Other variations within the scope of this disclosure are also applicable.

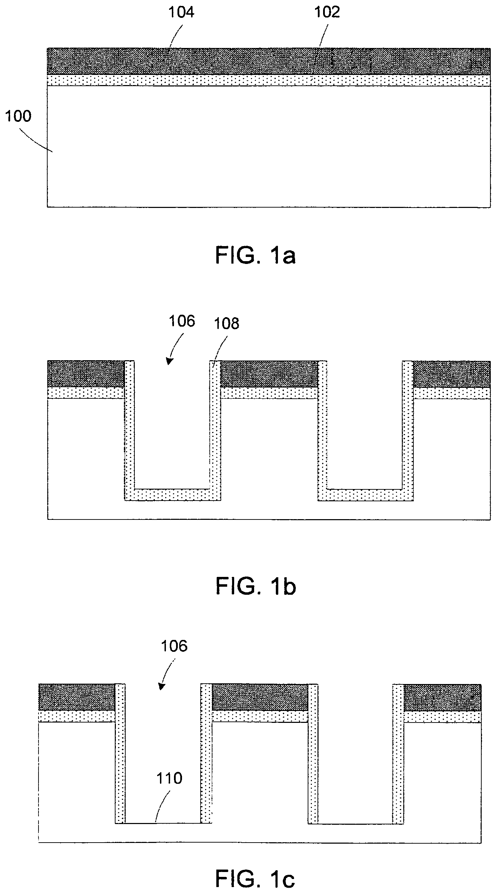

Referring to the drawings, FIG. 1a through FIG. 1d diagrammatically illustrate an exemplary method of making an epitaxial structure using an aspect-ratio-trapping (ART) technique. Referring to FIG. 1a, substrate 100 is provided, which can be a semiconductor crystalline substrate, such as a silicon substrate. Dielectric layer 102 comprised of a dielectric material is deposited on substrate 100. The dielectric material can be any suitable materials, which is preferably, though not required, an oxide or nitride of a semiconductor element, such as SiOₓ and SiNₓ. Other materials are also applicable, such as an oxide or nitride of a metal element, a metal alloy, or a ceramic material.

Screen layer 104 is deposited on dielectric layer 102. The screen layer is comprised of a material that is highly selective to the etching process to be used for etching substrate 100. For example, screen layer 104 can be comprised of TiNₓ when a dry etching process is to be performed for forming trenches in substrate 100.

The substrate (100) can be etched by a selected etching process so as to form openings, such as opening 106 in FIG. 1b. Due to the selectivity of the screen layer (104) to the etching process, the trench *(e.g.* 106) in the substrate (100) can have a larger depth or width while still maintaining the desired aspect ratio for the following ART growth. In one example, the opening (106) can have a depth of 100 nanometers or larger, 200 nanometers or larger, 500 nanometers or larger, 1 micron or larger, such as 1.5 micron or larger, 2 microns or larger, 3 microns or larger, or 5 microns or larger. The opening (106) may have a width of 20 nanometers or larger, 100 nanometers or larger, 500 nanometers or larger, 1 micron or larger, such as 1.5 micron or larger, 2 microns or larger, 3 microns or larger, or 5 microns or larger. The aspect ratio of the opening (106) can be 0.5 or higher, such as 1 or higher, 1.5 or higher.

The opening can then be filled with a selected dielectric material so as to coat the sidewalls (108) of the opening for the following ART growth in the opening. In one example, dielectric layer (108) at the sidewalls of the opening can be comprised of an oxide (*e.g.* SiOₓ), a nitride, (*e.g.* TiNₓ), or other suitable materials. In another example, the dielectric layer (108) at the sidewall of the opening can be comprised of TiNₓ or a material having a free- surface energy substantially equal to or higher than that of TiNₓ.

After coating the sidewalls of the opening (106), the dielectric layer can be etched so as to remove the dielectric material at the bottom portion (110) of the opening for exposing the underneath substrate (100), as diagrammatically illustrated in FIG. 1c.

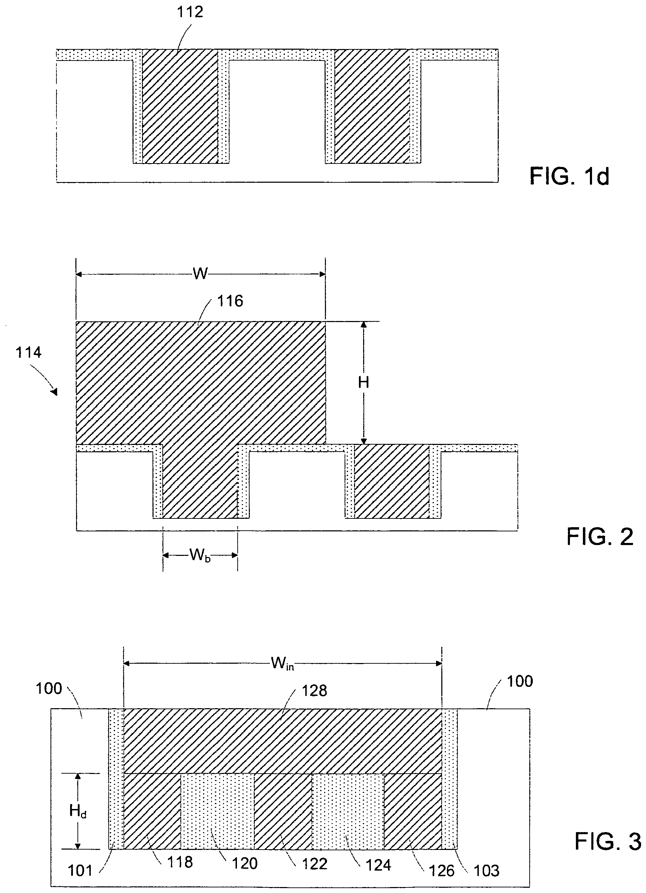

In the formed opening 106 as shown in FIG. 1c, an ART process can be performed so as to form epitaxial material 112 as diagrammatically illustrated in FIG. 1d. Exemplary methods for ART processes are set forth in US2006 292719 A1, US2007 181977 A1 and US2008 099785 A1. The ART structure is comprised of a semiconductor material. For example, the ART structure may be comprised of a group IV element or compound, a III-V or III-N compound, or a II-VI compound. Examples of group IV elements include Ge and Si; and examples of group IV compounds include SiGe (examples of III-V compounds include aluminum phosphide (AlP), gallium phosphide (GaP), indium phosphide (InP), aluminum arsenide (AlAs), gallium arsenide (GaAs), indium arsenide (InAs), aluminum antimonide (AlSb), gallium antimonide (GaSb), indium antimonide (InSb), and their ternary and quaternary compounds. Examples of III-N compounds include aluminum nitride (AlN), gallium nitride (GaN), indium nitride (InN), and their ternary and quaternary compounds. Examples of II-VI compounds includes zinc selenide (ZnSe), zinc telluride (ZnTe), cadmium selenide (CdSe), cadmium telluride (CdTe), zinc sulfide (ZnS), and their ternary and quaternary compounds.

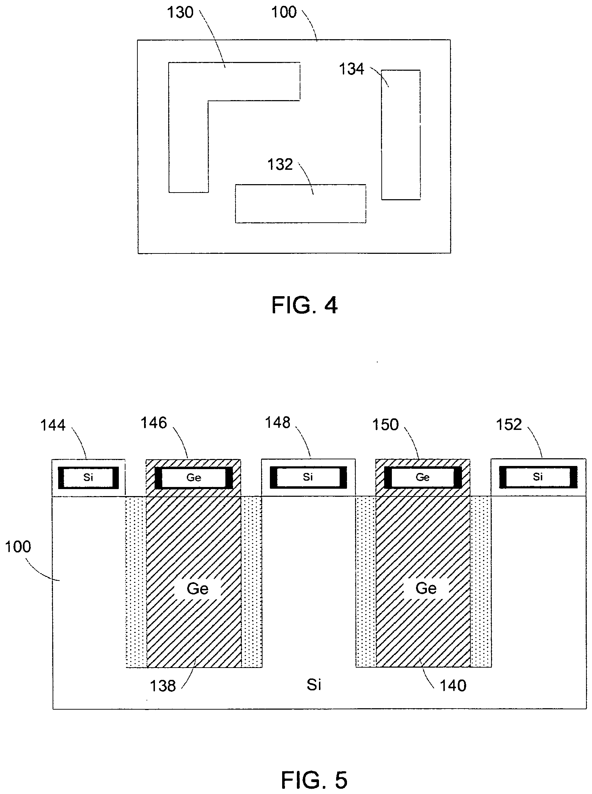

The above method of forming ART epitaxial structures and the epitaxial ART structures made thereof have many advantages. For example wherein the substrate is a silicon substrate, a non-silicon crystalline material, such as germanium or other semiconductor materials, can be formed in the trench of the substrate. As a consequence, a non-silicon semiconductor device can be formed at or in the non-silicon crystalline ART material, such as a germanium based ***p-n*** or ***p-i-n*** structure. Other silicon circuitry of the semiconductor device can thus be formed in or at the silicon substrate using standard silicon processes, as example of which will be described afterwards with reference to FIG. 5.

In another example, the above method enables photodetector pixels to be integrated into a silicon process. A photodetector pixel comprises a *p-n* or *p-i-n* structure and associated circuitry, such as signal converting circuits. In some applications, it is desired to make the *p-n* or *p-i-n* structure using a low band-gap material, such as Ge, InGaAs, SiGe, and InP for detecting infrared light. In some other examples, a ***p-n*** junction made from a high band-gap semiconductor material, such as GaN and InP) is desired for detecting ultra-violet light. The non-silicon semiconductor elements *(e.g.* the ***p-n*** junction or ***p-i-n*** structure) can be formed at or in the ART epitaxial structure comprised of the non-silicon semiconductor material, such as Ge and InGaAs. Other circuitry of the photodetector can be formed by using standard silicon processes, such as a standard CMOS process. When the photodetector is desired to have a size larger than a critical threshold, such as equal to or larger than 2 microns, or from 2 to 5 microns, an opening in the silicon substrate can be made to have a width equal to or larger than the desired size of the photodetector, such as equal to or larger than 2 microns, or from 2 to 5 microns. The ART epitaxial crystalline structure formed in the opening can thus have a width equal to or larger than the desired size of the photodetector. Further, desired A/R can simultaneously be maintained.

In addition to forming an ART epitaxial crystalline structure within a wide opening in a substrate, an ART with a large dimension can alternatively be obtained through overgrowing, as diagrammatically illustrated in FIG. 2. Referring to FIG. 2, an opening can have a width ***W_{b}*** is formed in a substrate using, for example a STI technique. By overgrowing the ART crystalline structure (114) within the opening, an overgrown crystalline portion (116) can be obtained. The overgrown crystalline portion (116) can have a height ***H*** that is 1.5 times or more, 2 times or more, 5 times or more, 10 times or more, or from 5 to 10 times of the height of the opening formed in the substrate. The overgrown crystalline portion (116) can have a width ***W*** that is 1.5 times or more, 2 times or more, 5 times or more, 10 times or more, or from 5 to 10 times of the width ***W_{b}*** of the opening formed in the substrate.

The large lateral dimension of the overgrown portion (116) can also be obtained from ELO (epitaxial-lateral-overgrowth). The ELO can be isotropic or anisotropic. For obtaining a flat surface of the overgrown portion (116), a CMP (chemical mechanical polishing) process can be performed. The overgrown portion (116) can further be patterned so as to obtain desired dimensions (lateral and vertical dimensions and/or the shape) using for example, a photolithography process.

A semiconductor device or an element of a semiconductor device having a large size *(e.g.* equal to or larger than 2 microns) can then be formed in the overgrown crystalline portion (116). For example, a *p-n* or *p-i-n* structure with a size of 100 nanometers or more, 500 nanometers or more, 1 micron or more, 2 microns or more, 5 microns or more, or 10 microns or more, or from 5 to 10 microns can be formed at or in the overgrown crystalline portion (116).

Large ART crystalline structures can alternatively be obtained by forming the ART crystalline structure within a large trench formed in a substrate, as diagrammatically demonstrated in FIG. 3. Referring to FIG. 3, an opening with a large width, such as 100 nanometers or larger, 500 nanometers or larger, 1 micron or larger, 2 microns or larger, 5 microns or larger, 10 microns or larger, or 100 microns or larger, and more preferably from 100 nanometers to 20 microns, and more preferably, from 2 to 5 microns, is formed in substrate 100 that can be a semiconductor crystalline substrate, such as a silicon substrate. Dielectric patterns, such as dielectric sidewall 101 and dielectric isolators 120 and 124 can be formed in the opening. The dielectric patterns are provided for enabling the following ART processes for forming ART epitaxial crystalline structures 118, 122, 126, and 128. Specifically, the dielectric patterns 101 and 120 define an opening with an aspect ratio commensurate with the aspect ratio needed for forming an ART epitaxial crystalline structure in the opening between patterns 101 and 120. The dielectric patterns 120 and 124 define an opening with an aspect ratio commensurate with the aspect ratio needed for forming an ART epitaxial crystalline structure in the opening between patterns 120 and 124. The dielectric patterns 124 and 103 define an opening with an aspect ratio commensurate with the aspect ratio needed for forming an ART epitaxial crystalline structure in the opening between patterns 124 and 103. Such dielectric patterns can be formed in multiple layers (e.g., stacked three or more vertically).

The dielectric patterns can be formed in many ways. In one example, after forming the large trench in substrate 100 by for example, a STI process, a dielectric layer having a dielectric material for dielectric patterns is deposited in the large opening. The deposited dielectric layer can be patterned to have a depth ***H_{d}*** measured from the bottom of the large opening to the top surface of the patterned dielectric layer. The depth ***H_{d}*** can have any suitable values, which is preferably equal to or larger than the threshold height within which the ART epitaxial structure formed in an opening (*e.g*. the opening between dielectric pattern 101 and 120) has dislocation defects.

The patterned dielectric layer in the large opening can be further patterned so as to form dielectric patterns 101, 120, 124, and 103. The bottom portions of the openings between dielectric patterns 101 and 120, between 120 and 124, and between 124 and 103 are removed so as to expose the substrate 100.

With the dielectric patterns formed in the large opening, an ART process can be performed so as to form ART epitaxial structures 118, 122, and 126. By overgrowing the ART structures 118, 122, and 126, overgrown crystalline portion 128 with a large size can be obtained. The overgrown crystalline portion (128) can have a width ***Wᵢₙ*** that is substantially equal to the width of the large opening formed in substrate 100. For example, the overgrown crystalline portion (128) can have a width ***Wᵢₙ*** of 100 nanometers or larger, 500 nanometers or larger, 1 micron or larger, 2 microns or larger, 5 microns or larger, 10 microns or larger, or 20 microns or larger, and more preferably, from 2 to 5 microns.. A semiconductor device or an element of a semiconductor device with a desired large size *(e.g.* 100 nanometers or larger, 500 nanometers or larger, 1 micron or larger, 2 microns or larger, 5 microns or larger, 10 microns or larger, or 20 microns or larger, and more preferably, from 2 to 5 microns) can thus be formed at or in the overgrown crystalline portion (128).

The openings formed in a substrate by using trenches, openings or the like as described above can have any desired shapes or layouts, an exemplary of which is diagrammatically illustrated in a top view in FIG. 4. Referring to FIG. 4, an opening can have other shapes such as a 90° angle shape, such as opening 130. Of course, an opening can have other shapes, such as circular, donut, polygonal, and many other possible shapes. Multiple openings can be formed in the opening with any desired layouts. For example, rectangular openings 134 and 132 can be perpendicular or parallel or can be arranged to have any desired angles therebetween.

Exemplary methods as described above with reference to FIG. 1a through FIG. 1d or FIG.2 can enable integration of non-silicon semiconductor devices into a silicon process. For demonstration purposes, FIG. 5 diagrammatically illustrates one of the examples. Referring to FIG. 5, openings are formed by using a STI process in silicon substrate 100. Germanium (or InGaAs or other semiconductor materials such as a III-V group semiconductor material) ART crystalline structures 138 and 140 are formed in the STI openings in silicon substrate 100. Germanium based (or InGaAs or other semiconductor materials such as a III-V group semiconductor material based) semiconductor devices 146 and 150, such as photodetectors are formed at ART structures 138 and 140. A buffer layer (e.g., 10-100nm) can be between the substrate 100 and the ART crystalline structures 138 and 140 for bonding, adhesion or improved device characteristics purposes. Silicon based devices or elements of semiconductor devices 144, 148 and 152 are formed at the patterns of substrate 100 using standard silicon processes, such as CMOS processes. As such, non-silicon semiconductor devices of elements of non-silicon based semiconductor devices are integrated (e.g., co-planar) in the silicon process.

In examples of forming ART epitaxial structures in STI trenches that are formed in a substrate, such as a silicon substrate, the substrate patterns, such as the silicon patterns around the openings, can be treated. For example, the substrate patterns can be intentionally passivated for protecting the substrate patterns and the ART structures. This can be of great importance when the thermal and/or mechanical properties of the substrate and the ART structures mismatch, which may cause physical and/or chemical damages to the ART structures and/or to the substrate patterns due to the mismatch. For example, physical damages may occur to the ART structures and/or the substrate patterns when the CET (coefficient-of-thermal-expansion) of the ART structures and the substrate patterns do not match. In one example, the substrate patterns can be passivated by oxidization or nitridization so as to form a protection layers on the exposed surfaces of the substrate patterns or the interfaces between the substrate patterns and the ART structures.

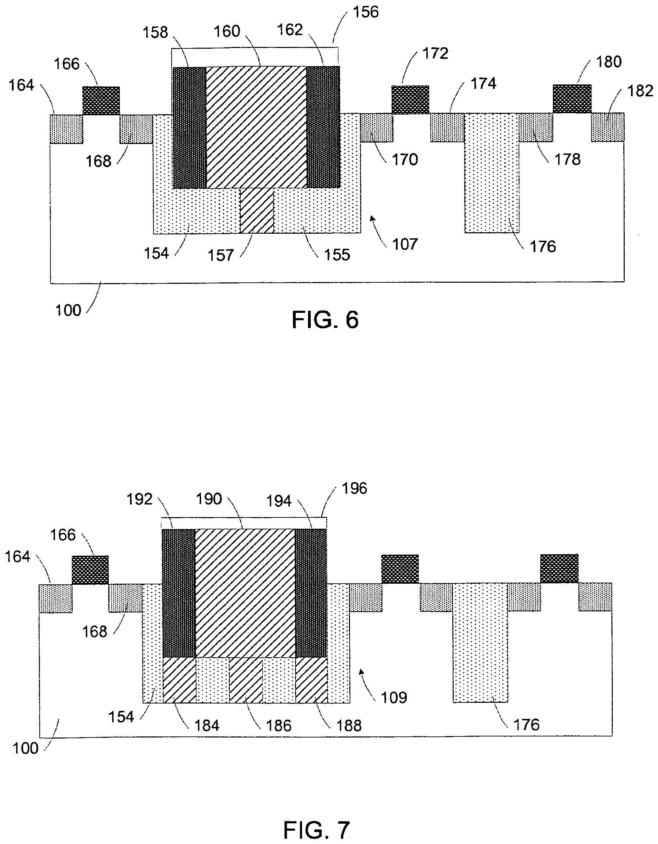

As an exemplary implementation of the method and the structure as described above with reference to FIG. 2, an exemplary structure having a *p-i-n* structure formed in an ART epitaxial crystalline structure is diagrammatically illustrated in FIG. 6. Referring to FIG. 6, STI trench 107 is formed in semiconductor substrate 100, which can be a silicon substrate or other semiconductor substrates. Isolation patterns 154 and 155 are formed within the STI trench (107) and define opening 157 therebetween. Opening 157 can have a height that is substantially equal to or larger than the critical height under which the ART crystalline structure formed in the opening 157 has dislocation defects and above which the ART crystalline structure is substantially free from dislocation defects. An ART epitaxial crystalline structure can be grown in opening 157. By overgrowing the ART structure in opening 157, a large ART overgrown portion 156 is obtained.

A ***p-i-n*** structure having ***p***-type region 158, intrinsic region 160, and ***n***-region 162 is formed in overgrown crystalline portion 156. The ***p***-type region 158 and the ***n***-type region 162 can be obtained by doping. Because the overgrown crystalline portion 160 can have a large size, such as 100 nanometers or larger, 500 nanometers or larger, 1 micron or larger, 2 microns or larger, 5 microns or larger, 10 microns or larger, or 20 microns or larger, and more preferably, from 2 to 5 microns, the intrinsic *i* region 160 can be large, such as 100 nanometers or larger, 500 nanometers or larger, 1 micron or larger, 2 microns or larger, 5 microns or larger, 10 microns or larger, and more preferably, from 2 to 5 microns.

Other circuitry can be formed on the patterned semiconductor substrate 100, such as the transistor having source 164, gate 166, and drain 168, the transistor having source 170, gate 172, and drain 174, and the transistor having source 178, gate 180, and drain 182. The source, gate, and drain of a transistor can be formed by a standard silicon process, such as a CMOS process. For example, the sources and drains of the transistors can be formed by doping; and the gates of the transistors can be formed by a standard silicon based lithography process. Other features can also be formed in the substrate (100). For example, isolation unit 176 can be formed between transistors so as to isolating the transistors. In one example, the semiconductor device (*e.g*. 156) formed on the ART structure can be substantially coplanar with one or more other semiconductor devices (e.g. transistors) on substrate 100. For example, the top surfaces of 158, 160, and 162 of device 156 can be made substantially coplanar with the transistors formed on substrate 100.

As an exemplary implementation of the method and the structure as described above with reference to FIG. 3, an exemplary structure having a *p-i-n* structure formed in an ART epitaxial crystalline structure is diagrammatically illustrated in FIG. 7. Referring to FIG. 7, STI trench 109 is formed in semiconductor substrate 100, which can be a silicon substrate or other semiconductor substrates. Multiple isolation patterns, such as dielectric pattern 154 are formed within the STI trench (109) using for example the method as described above with reference to FIG. 3, which will not be repeated herein. Openings 184, 186, and 188 are defined by the isolation patterns.

ART epitaxial crystalline growth can be performed in the openings 184, 186, and 188. By overgrowing or through the combination of overgrowing and coalescing of ELO portions of the ART structures in openings 184, 186, and 188, overgrown crystalline portion 196 is obtained. The overgrown crystalline portion 196 can have a large dimension, such as a lateral and/or vertical dimensions of 100 nanometers or larger, 500 nanometers or larger, 1 micron or larger, 2 microns or larger, 5 microns or larger, 10 microns or larger, and preferably, from 2 to 5 microns.

A *p-i-n* structure having ***p***-type region 192, intrinsic region 190, and ***n***-region 194 is formed in overgrown crystalline portion 196. The ***p***-type region 192 and the ***n***-type region 194 can be obtained by doping. Because the overgrown crystalline portion 196 can have a large size, the intrinsic i region 190 can be large, such as 100 nanometers or larger, 500 nanometers or larger, 1 micron or larger, 2 microns or larger, 5 microns or larger, 10 microns or larger, and more preferably from 100 nanometers to 200 microns, and preferably, from 2 to 5 microns.

Other circuitry can be formed on the patterned semiconductor substrate 100, such as the transistor having source 164, gate 166, and drain 168. The source, gate, and drain of a transistor can be formed by a standard silicon process, such as a CMOS process. For example, the sources and drains of the transistors can be formed by doping; and the gates of the transistors can be formed by a standard silicon based lithography process. Other features can also be formed in the substrate (100). For example, isolation unit 176 can be formed between transistors so as to isolating the transistors. In one example, the semiconductor device (*e.g*. 196) formed on the ART structure can be substantially coplanar with one or more other semiconductor devices (*e.g*. transistors) on substrate 100. For example, the top surfaces of 192, 190, and 194 of device 196 can be made substantially coplanar with the transistors formed on substrate 100.

As can be seen in the examples as illustrated in FIG. 6 and FIG. 7, lateral ***p-i-n*** structures or ***p-n*** junctions can be made in ART epitaxial crystalline semiconductor structures, wherein the semiconductor structures can be comprised of non-silicon materials. For example, the carrier channel from the ***p*** region to the ***n*** region of a lateral ***p-i-n*** or ***p-n*** junction is parallel to the major surface of the substrate (100) or is substantially perpendicular to the direction along which the ART epitaxial crystalline materials are formed.

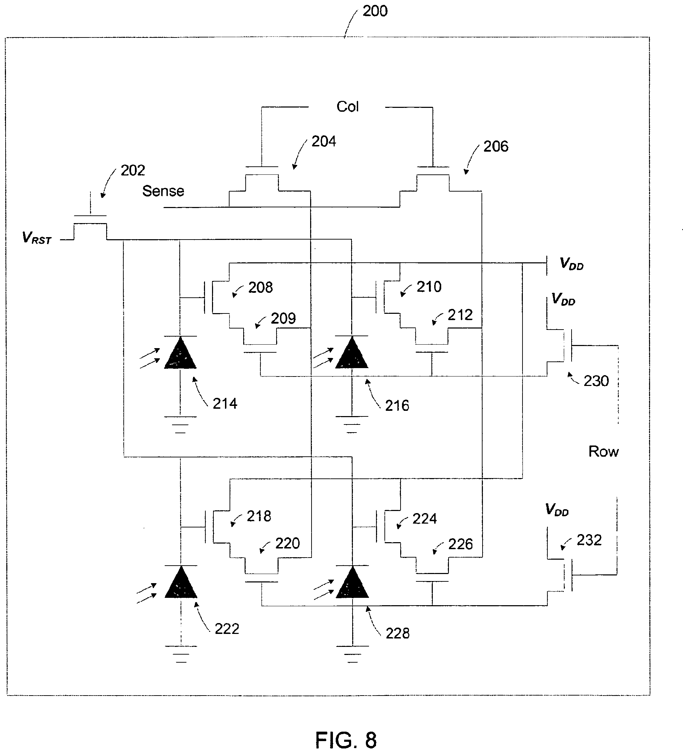

The method of making a semiconductor device can be of great importance in making photodetector pixels that are comprised of an array of ***p-i-n*** structures. For demonstration purposes, FIG. 8 through FIG. 14 diagrammatically demonstrate a portion of an array of photodetector pixels that are formed by exemplary methods as described above. In particular, non-semiconductor devices *(e.g. no*n-silicon semiconductor sensor 214) can be integrated with silicon semiconductor devices (*e.g.* silicon transistors 208, 209, 202, and 204) using the method as discussed above. Referring to FIG. 8, four photodetector pixels of the photodetector array are shown for simplicity purposes. In general, the photodetector array may comprise any desired number of photodetector pixels, which is referred to as the native resolution of the photodetector array. In one example, the photodetector array may have a native resolution of 640x480 (VGA) or higher, such as 800x600 (SVGA) or higher, 1024x768 (XGA) or higher, 1280×1024 (SXGA) or higher, 1280 × 720 or higher, 1400 × 1050 or higher, 1600 × 1200 (UXGA) or higher, and 1920 × 1080 or higher, or integer multiples and fractions of these resolutions. Of course, other resolutions are also applicable depending upon specific applications.

Each photodetector can have a characteristic size of less than 500 nanometers, 500 nanometers or larger, 1 micron or larger, such as 1.5 microns or larger, 2 microns or larger, 5 microns or larger, 10 microns or larger, or from 5 to 10 microns. The pitch, which is referred to as the distance between adjacent photodetectors in the array, can be any suitable values, such as 500 nanometers or larger, 1 micron or larger, such as 1.5 microns or larger, 2 microns or larger, 5 microns or larger, 10 microns or larger, or from 5 to 10 microns.

The portion of the exemplary photodetector array 200 comprises transistors 202, 204, 206, 208, 209, 210, 212, 218, 220, 224, 226, 230, and 232, and photo-sensors 214, 216, 222, and 228. The photo-sensors convert the light energy into voltage signals, and a group of transistors amplify the voltage signals (and convert the amplified voltage signals into digital signals if necessary). Another group of transistors can be provided for addressing and reading out the outputs of individual photodetector pixels in the columns and rows of the array by column and row addressing/reading signals.

For example, sensor 214 converts the received light intensity into a voltage signal. When an active signal (column signal) is delivered to transistor 209 through transistor 204 from a column decoder (which not shown in the figure), the output voltage signal from sensor 214 is amplified by transistor 208. When a row signal (row active signal) is delivered to the gate of transistor 209 through transistor 230, the amplified voltage signal ***V_{DD}*** is read out through the output of transistor 208. The output voltage signal ***V_{DD}*** can be digitized by other devices, such as an ADC unit, which is not shown in the figure.

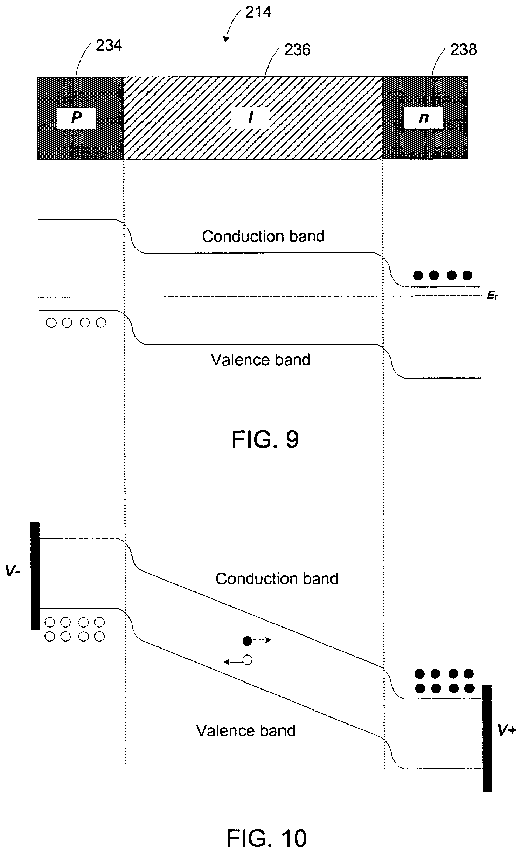

The sensors (214, 216, 222, and 228) each can be a ***p-i-n*** structure as diagrammatically illustrated in FIG. 9. Referring to FIG. 9, sensor 214 comprises ***p*** region 234, ***i*** region 236, and ***n*** region 238. The *p-i-n* structure (214) can be formed in many ways, such as those described above with reference to FIG. 5, FIG. 6, and FIG. 7. Electron transportations properties of the *p-i-n* structure can be interpreted by energy band diagrams as diagrammatically illustrated in FIG. 9 and FIG. 10.

Referring to FIG. 9, the conductive and covalence bands of the *p* region 234, *i* region 236, and ***n*** region 238 are substantially flat in the absence of external voltages. Fermi energy ***E_{f}*** is close to the covalence band of the *p* region such that the *p* region is a hole-rich region. Because the ***i*** region is an intrinsic semiconductor region, the Fermi energy ***E_{f}*** is around the center of the gap between the covalence and conductive bands. Fermi energy ***E_{f}*** is close to the conductive band of the *n* region such that the *n* region is an electron-rich region.

In the presence of external voltage *V+* and *V-* respectively applied to the ***n*** and ***p*** regions, as diagrammatically illustrated in FIG. 10, the conductive and covalence bands of the *p* region is elevated; while the conductive and covalence bands of the ***n*** region is declined. As a consequence, the conductive and covalence bands of the intermediate **i** region inclines. The Fermi energy ***E_{f}*** also inclines the energy gap of the ***i*** region. The inclined Fermi energy drives electrons in the ***i*** region towards the *n* region; and holes in the *i* region toward the *p* region. This transportation of electrons and holes forms current in a carrier channel connecting the *p* and *n* regions.

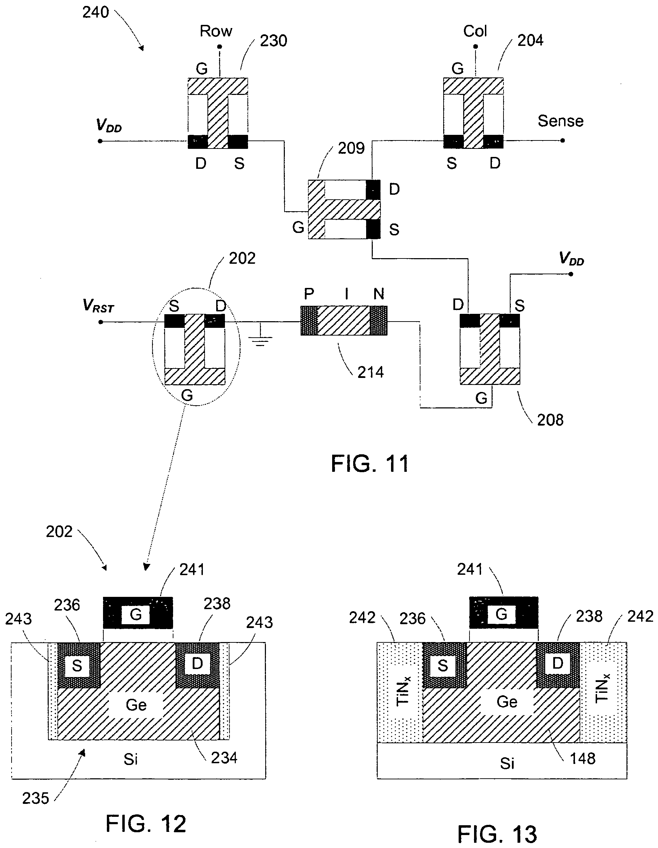

The transistors and sensors of the photodetectors illustrated in FIG. 8 can be formed on ART epitaxial crystalline structures, which can be better illustrated in FIG. 11. For simplicity purposes, sensor 214 and the transistors around sensor 214 are shown in FIG. 11. The exemplary connection of sensor 214 to the transistors is also applicable to other sensors and transistors.

Referring to FIG. 11, sensor 214 has ***p,i,*** and ***n*** regions; and sensor 214 can be a non-silicon semiconductor device. The transistors 202, 204, 208, and 209 can be silicon based transistors. The ***p*** region is grounded and is connected to the drain of transistor 202. The source of transistor 202 is connected to reset signal ***p*** region ***V_{RST}.*** The *p* region of sensor 214 is connected to the gate of transistor 208. The source of transistor 208 acts as an output for outputting amplified voltage signal ***V_{DD}**.* The drain of transistor 208 is connected to the source of transistor 209. The gate of transistor 209 is connected to the source of row selection transistor 230, whose gate is connected to the row signal from a row decoder. The drain of transistor 230 is connected to amplified voltage signal ***V_{DD}.***

The drain of transistor 209 is connected to the source of column selection transistor 204, whose gate is connected to the column signal from a column decoder. The drain of row selection transistor 204 is connected to a sense signal.

The transistors in FIG. 11 can have any suitable configurations. In particular, the non-silicon semiconductor sensor (214) can be integrated with the silicon-based transistors (e.g. 202, 208, 209, 204, and 230). Alternatively, the transistors such as transistor 202 can be other types of transistors, such as germanium (or other silicon or non-silicon) based transistors as diagrammatically illustrated in FIG. 12. Referring to FIG. 12, a trench 235 or an opening is formed in a silicon substrate. The sidewalls of the trench are covered with a dielectric layer, such as an oxide layer 243. The sidewall cover layer (243) can be formed in many ways. For example, the sidewall cover layer (243) can be formed by depositing or growing the sidewall cover layer in the trench followed by removing the cover layer on the bottom surface of the trench. Alternatively, the trench can be filled with the sidewall cover layer followed by patterning/etching to form the desired sidewall cover layer in the trench. A germanium (or other silicon or non-silicon semiconductor materials) epitaxial crystalline structure 234 is formed in the trench of the silicon substrate using, for example, the method as discussed above with reference to FIG. 6. Source 236 and drain 238 of the transistor are formed in the germanium epitaxial crystalline structure (234) by doping. Gate 241 is formed on the germanium crystalline structure with an oxide layer laminated therebetween.

Another exemplary configuration of the transistors in FIG. 11 is diagrammatically illustrated in FIG. 13. Referring to FIG. 13, the transistor is formed on a silicon substrate. Dielectric patterns 242 are formed so as to define an opening on the silicon substrate. The dielectric patterns can be formed by depositing a layer of a selected dielectric material, such as TiNₓ on the silicon substrate followed by patterning the deposited dielectric layer.

The opening defined by the dielectric patterns has an appropriate aspect ratio, such as 0.5 or larger, 1 or larger, 1.5 or larger or 3 or larger, such that an ART growth process can be performed within the opening. Germanium epitaxial crystalline structure 148 can then be formed in the opening through an ART process. By doping portions of the germanium crystalline structure, source 236 and drain 238 can be obtained with an intrinsic region being laminated therebetween. Gate 241 can be formed above the germanium epitaxial crystalline structure with an oxide layer disposed therebetween.

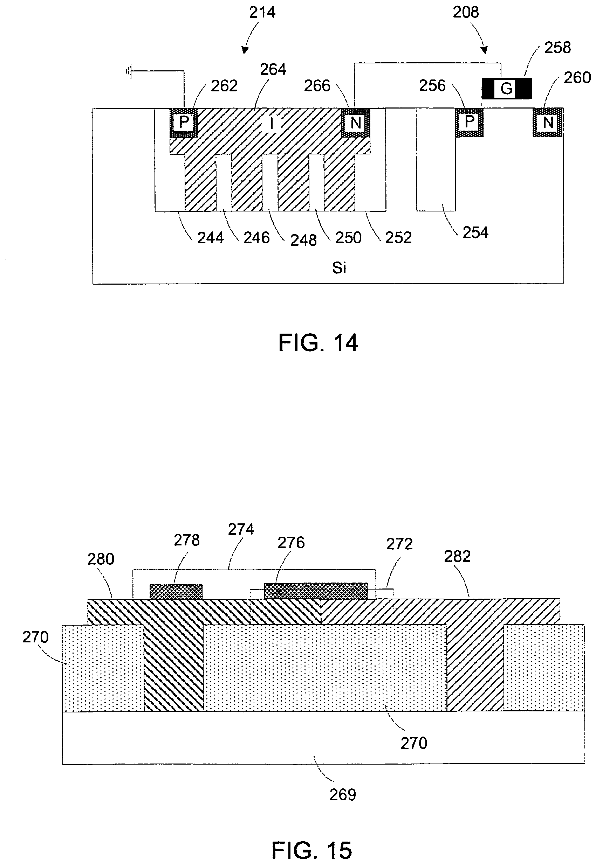

In examples wherein the sensors of the photodetectors illustrated in FIG. 11 desired large areas, such as 1 micron or larger, 2 microns or larger, 5 microns or larger, 10 microns or larger, or from 5 to 10 microns, the ***p-i-n*** structure of the sensor can be formed using methods as described above with reference to FIG. 1, FIG. 2 or FIG. 7 or the like. For demonstration purposes, FIG. 14 diagrammatically illustrates an exemplary electrical connection of the *p-i-n* structure of the sensor to a transistor. This connection scheme is also applicable to connections of other sensors and transistors.

Referring to FIG. 14, an array of STI process trench structures (or other types of trench structures) 244, 246, 248, 250, and 252 are formed in a silicon substrate. The STI process trench structures can be formed by multiple patterning processes. For example, a patterning process can be performed so as to define the STI process opening from the top surface of the silicon substrate to the top surfaces of STI process patterns 214 and 254. Within the defined opening, another patterning process can be performed so as to define STI process patterns 244, 246, 248, 250, and 252 within the previously defined opening 214.

The adjacent STI patterns of the array of STI patterns 244, 246, 248, 250, and 252 define a series of openings, each of which has an aspect ratio commensurate with the aspect-ratio(s) desired for the following ART processes. With the series of openings between STI patterns 244, 246, 248, 250, and 252, an ART process is performed using a germanium (or other semiconductor materials, such as InGaAs and III-V group materials) so as to form an ART epitaxial crystalline structure. As described above with reference to FIG. 1d or FIG. 7, a large ART portion can be formed above the openings and STI patterns by overgrowing the ART structures or by coalescing the ELO portions of the adjacent ART structures. Regardless of the growing process, the ART portion (264) can have the top surface that is substantially coplanar to the substrate (e.g. the silicon substrate) or can be above the top surface of the silicon substrate. Accordingly, the semiconductor device (or structure) formed on the ART structure (e.g. 264) can be substantially coplanar to another semiconductor device (e.g. the transistor having source 256, gate 258, and drain 260) formed at the top surface of the substrate. The p-i-n structures can then be formed in the large ART portion. Specifically, the p and n regions can be obtained by doping the intrinsic large ART portion with appropriate dopants. The intrinsic i region can have a large size, such as 1 micron or larger, 1.5 microns or larger, 2 microns or larger, 5 microns or larger, 10 microns or larger, or from 5 to 10 microns.

An insulation structure 254 can be formed by a STI process. Transistors having source 256, drain 260, and gate 258 can be formed on the silicon substrate by using a standard silicon process, such as a CMOS process. The *p* region of the ***p-i-n*** structure of the sensor (214) is grounded. The ***n*** region of the *p-i-n* structure is connected to the gate of transistor 208.

Other than forming a semiconductor device, such as a photodetector, a transistor, a LED or a laser, on a dislocation-free region in an epitaxial crystalline ART structure, the semiconductor device can alternatively be formed on a coalesced region between adjacent ART structures, an example of which is diagrammatically illustrated in FIG. 15. Referring to FIG. 15, substrate 269, which can be a semiconductor substrate, such as a silicon substrate is provided. Dielectric layer 270 is deposited on the substrate followed by patterning so as to generate openings in the dielectric layer. An ART process can be performed to form ART epitaxial crystalline structures 280 and 282. By overgrowing the ART structures, the ELO portions of the adjacent ART structures 280 and 282 can be coalesced to form a coalesced region 272. Semiconductor device 276, such as a ***p-i-n*** structure or ***p-n*** junction, a transistor, or other semiconductor devices can be formed at or in the coalesced region (272). Element 276 can alternatively be a member of semiconductor device 274 that further comprises member 278, which can be formed at the non-coalesced ART region, such as the non-coalesced region of ART structure 280.

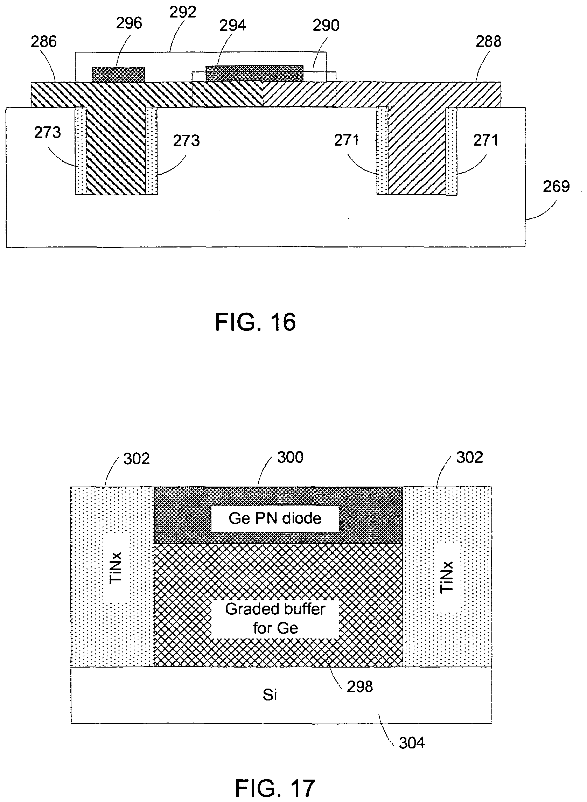

Alternative to forming semiconductor devices on coalesced region of adjacent ART structures that are formed in openings defined by dielectric patterns as described above with reference to FIG. 15, a semiconductor device can be formed at or in a coalesced region of adjacent ART structures that are formed in substrates, trenches, STI trenches or openings, an example of which is diagrammatically illustrated in FIG. 16.

Referring to FIG. 16, ART epitaxial crystalline structures 286 and 288 are formed from STI trenches in substrate 269, which can be a semiconductor substrate, such as a silicon substrate, wherein the sidewalls of the trenches are covered by dielectric layers 271 and 273, which may be comprised of an oxide material or other suitable materials. The dielectric layer can be formed in the same way as the dielectric layer 243 in FIG. 12. The ELO portions of ART structures 286 and 288 coalesce resulting in coalesced region 290. Semiconductor device 294, such as a ***p-i-n*** or ***p-n*** junction, a transistor, or other semiconductor devices can be formed at or in the coalesced region (290). Element 294 can alternatively be a member of semiconductor device 292 that further comprises member 296, which can be formed at the non-coalesced ART region, such as the non-coalesced region of ART structure 286.

In addition to the methods described above, integration of a non-silicon based semiconductor device into a silicon process can alternatively be achieved by using buffer layers. Graded buffer layers can be of great value for heteroepitaxy growth, such as heteroepitaxy growth on silicon. As a way of example, graded buffer layers can be used for heteroepitaxy (*e.g*. in silicon) in relatively larger areas as compared to the narrow trench areas *(e.g.* STI trench structures as in examples of ART). FIG. 17 diagrammatically illustrates an example. Referring to FIG. 17, in order to form a non-silicon based semiconductor device, such as a germanium (or other semiconductor materials, such as InGaAs and III-V group semiconductor materials) semiconductor device (*e.g*. a ***p-n*** or ***p-i-n*** structure) on a silicon substrate, a graded buffer layer comprised of a selected semiconductor material is deposited on the silicon substrate. The graded buffer layer may have a size *(e.g.* the lateral or vertical dimension) such as 100 nanometers or larger, 500 nanometers or larger, 1 micron or larger, 2 microns or larger, 5 microns or larger, 10 microns or larger, or 100 microns or larger, 1 millimeter or larger, 200 millimeters or larger, 500 millimeters or larger, 1 centimeter or larger, or from 10 microns to several centimeters, such as from 10 microns to 500 microns, from 10 microns to 1 millimeter, from 10 microns to 500 millimeters or from 10 microns to 1 centimeter. The graded buffer layer may have other suitable lateral/vertical dimensions in other examples. In the particular example as illustrated in FIG. 17, dielectric patterns 302 of a selected dielectric material, such as TiNₓ are formed on silicon substrate 304 and define an opening. In order to form a germanium ***p-n*** diode on the silicon substrate (304), graded buffer layer 298 for germanium is deposited in the opening on the silicon substrate (304). In other examples, the buffer can be comprised of other suitable materials, such as GaAs, a III-V group semiconductor material (*e.g.* SiGe, InGaAs, and InP), or a laminate of GaAs/InP/InGaAs. The graded buffer layer can be formed in may ways such as epitaxial techniques and other suitable techniques.

Germanium *p-n* diode 300 can then be formed on the graded buffer layer (298) for germanium. It is noted that depending upon different semiconductor devices to be formed on the silicon substrate (304), the graded buffer layer can be comprised of different materials to match the semiconductor device to be formed thereon.

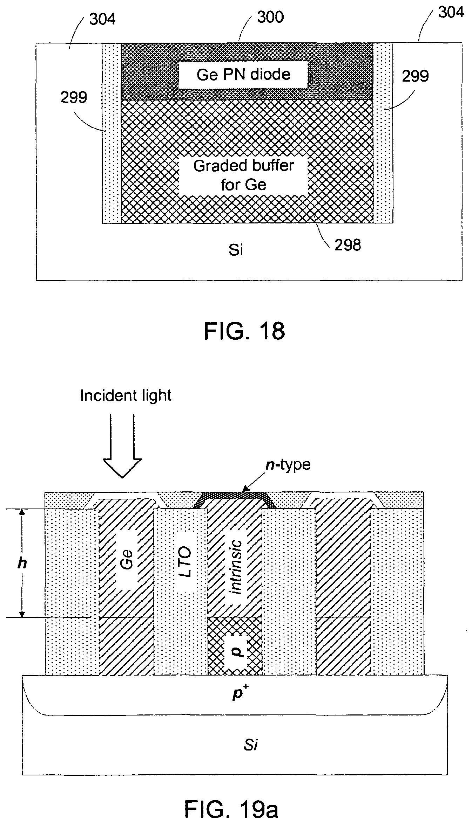

The graded buffer layer can also be used for making semiconductor devices in trenches such as STI trenches formed in a semiconductor substrate, as diagrammatically illustrated in FIG. 18. Referring to FIG. 18, a STI trench is formed in silicon substrate 304. The sidewalls of the trench are covered by dielectric layer 299, which can be comprised of an oxide material or other suitable materials. The dielectric layer can be formed in the same way as the dielectric layer 243 in FIG. 12. A graded buffer layer 298 is disposed in the STI trench. Depending upon the semiconductor device to be formed on the buffer layer and the silicon substrate, the graded buffer layer can be comprised different materials. In the example as illustrated in FIG. 18 wherein a germanium ***p-n*** diode is to be formed, the graded buffer layer is correspondingly comprised of a material for matching germanium. Germanium ***p-n*** diode 300 is formed on buffer layer 298.

A graded buffer layer may itself comprise a substantially defect (*e.g*. dislocation defect) free layer; and a device layer for forming a semiconductor device *(e.g.* a transistor, a photodetector, a solar cell, or other devices) can be formed on such defect free layer. The graded buffer layer may have a size *(e.g.* the lateral or vertical dimension) such as 100 nanometers or larger, 500 nanometers or larger, 1 micron or larger, 2 microns or larger, 5 microns or larger, 10 microns or larger, or 100 microns or larger, 1 millimeter or larger, 200 millimeters or larger, 500 millimeters or larger, 1 centimeter or larger, or from 10 microns to several centimeters, such as from 10 microns to 500 microns, from 10 microns to 1 millimeter, from 10 microns to 500 millimeters or from 10 microns to 1 centimeter. The graded buffer layer may have other suitable lateral/vertical dimensions in other examples. The graded buffer layer can be formed on a substrate (e.g. a silicon substrate), or in a region, such as a trench (*e.g*. a STI trench or other types trenches) that is formed in a substrate or in a dielectric or insulator layer above a substrate.

Referring to FIG. 19a, a cross-sectional view of a portion of an exemplary array of photodetectors is diagrammatically illustrated therein. A heavily doped ***p***+region is formed in a silicon substrate. The p+ region can then be used as a lower contact for the photodetectors. A dielectric layer, which is comprised of a low-temperature-oxide (LTO) material in this example, is deposited on the silicon substrate *(e.g.* on the *p*+ region in the silicon substrate). The deposited LTO layer is patterned so as to form openings and expose the silicon substrate, especially, the ***p***+ region in the silicon substrate. ART epitaxial crystalline structures of a selected material, such as germanium or a III-V group semiconductor material are formed in the openings. The ART structures can be grown with in-situ doping until past the defect regions. The in-situ doped defect-regions can be formed as ***p***-type regions. The ART process can continue until the thickness (*e.g. L*) is sufficient to allow for desirable levels of absorption of incident light that the photodetector is designed for detecting, such as visible light, ultraviolet light, and/or infrared light. The top portion of the ART structures can then be doped with an appropriate material so as to form ***n***-type regions.

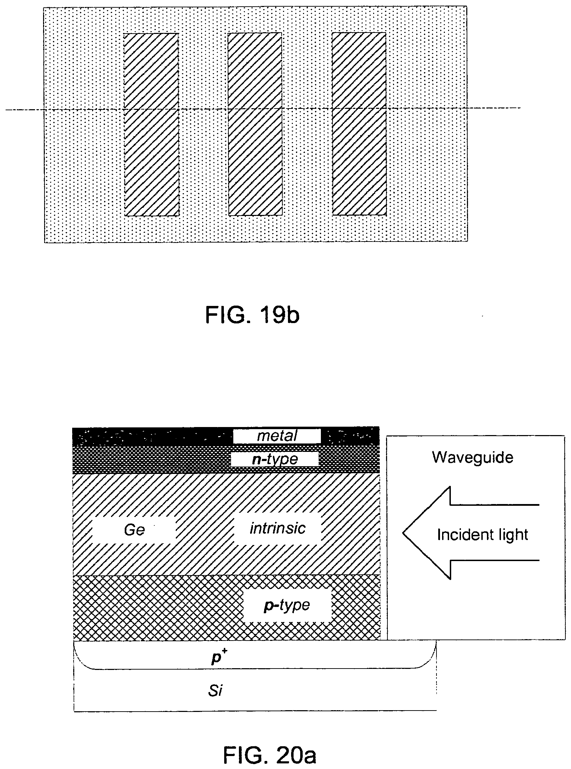

A top view of the photodetectors in FIG. 19a is diagrammatically illustrated in FIG. 19b. Referring to FIG. 19b, three photodetectors are shown for simplicity and demonstration purposes. As discussed above, the photodetector array may comprise any desired number of photodetectors.

The photodetectors in FIG. 19a and 19b are configured such that the ***p,** i,* and ***n*** regions of each photo sensor *(e.g.* the ***p-i-n*** structures) are vertically aligned along the growth direction of the ART structures. In photo detection application, light to be detected is directed toward the top of the sensors. In an alternative example, the light to be detected can be directed along the side of the sensors, as diagrammatically illustrated in FIG. 20a.

Referring to FIG. 20a, a heavily doped ***p*+** region is formed in an intrinsic silicon substrate. An ART epitaxial crystalline material comprised of germanium or a III-V semiconductor material is grown in openings of a dielectric layer, such as the dielectric layer comprised of a LTO material in FIG. 19a. With in-situ implantation, ***p*** region can be formed in the ART structures, especially the defect regions of the ART structures. The ART structures continue to form the intrinsic regions. By in-situ or other doping techniques, ***n***-regions can be formed in the top regions of the ART structures. A metal contact then can be formed on and physically contact to the ***n***-regions.

In light detection application, light to be detected is directed from the side of the photodetector as diagrammatically illustrated in FIG. 20a. This configuration allows for light detection to occur in-plane with the silicon substrate. Furthermore, it allows for the growth thickness of ART structures to be independent from the absorption depth.

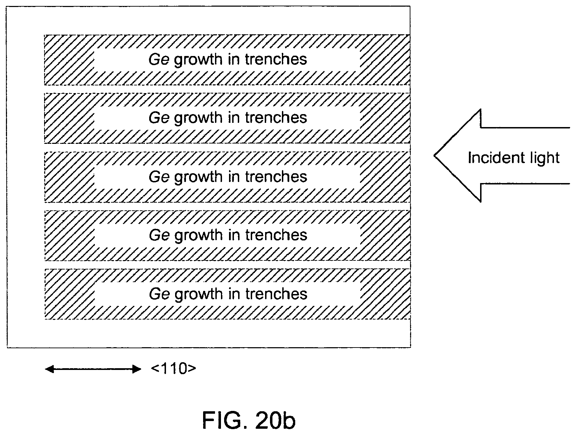

A top view of the photodetectors is diagrammatically illustrated in FIG. 20b. Referring to FIG. 20b, germanium (or other semiconductor materials, such as a III-V semiconductor material) epitaxial crystalline ART structures are formed on a substrate (e.g. on the heavily doped ***p*+** region formed in the silicon substrate). The germanium ART structures in this example are deployed such that the lengths (in the top view) of the germanium ART structures are aligned to the <110> direction of the silicon substrate, however the application is not intended to be so limited as other alignments are considered available. The incident light to be detected is directed toward the side of the germanium ART structures.

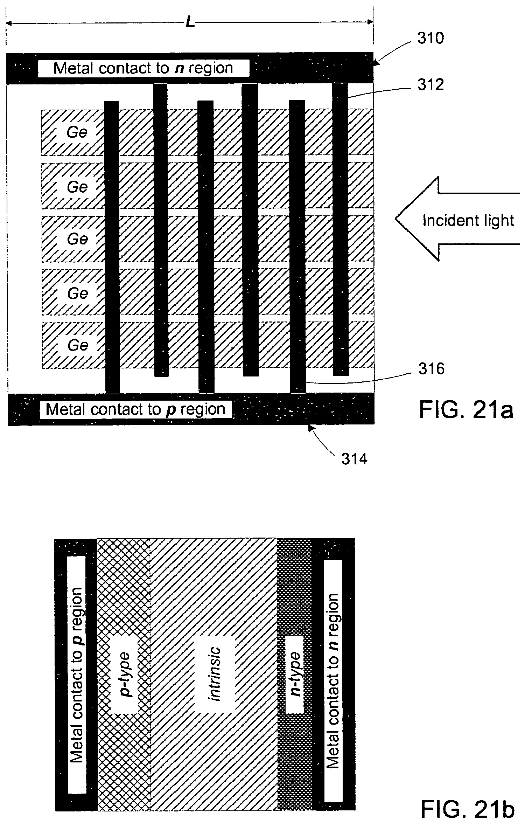

The electrical connection of the photodetectors as illustrated in FIG. 20a and FIG. 20b can have many suitable configurations, one of which is diagrammatically illustrated in FIG. 21a and FIG. 21b. Referring to FIG. 21a, the exemplary electrical connection scheme is illustrated in a top view. A contact to *n* region and a contact to *p* region are provided. Each contact comprise at least an elongated contact beam that spans across and electrically connected to substantially all regions of a particular type *(e.g.* the ***n*** or the *p* type) of the photodetectors. For example, metal contact 310 for contacting to ***n*** regions comprises contact beam 312. Contact beam 312 spans across substantially all ART structures; and is connected to the ***n*** regions of the ART structures. This connection is better illustrated in FIG. 21b that diagrammatically illustrates the connection of the metal contacts to the ***p*** and ***n*** regions of a *p-i-n* structure in a photodetector.

Metal contact 314 comprises at least one contact beam, such as contact beam 316. The contact beam spans across substantially all photodetectors; and is electrically connected to the ***p*** regions of the photodetectors. This connection is better illustrated in FIG. 21 b.

In order to improve the quality and reliability of the electrical connection between the metal contacts to their designated regions, each contact may comprise multiple contact beams as diagrammatically illustrated in FIG. 21a. In the example as illustrated in FIG. 21a, the contact beams of each metal contact are uniformly deployed across the photodetectors within the light absorption range ***L*.** Contact beams of different contacts can be alternately disposed. Other configurations are also applicable. For example, multiple (*e.g.* 2 or more) contact beams of one metal contact can be disposed between two adjacent contact beams of the other contact.

In another exemplary configuration, a contact beam of a metal contact can be connected to a group of photodetectors but not all photodetectors. The photodetectors not electrically connected to one contact beam can be electrically connected to another contact beam. In other words, a metal contact can have at least two contact beams that are electrically connected to two different groups of photodetectors; whereas the two different groups have at least one different photodetector.

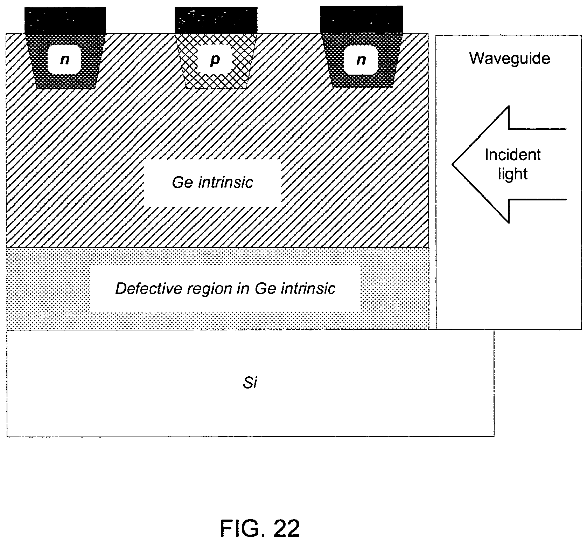

The method as described above can be applied to make semiconductor devices formed in or at ART structures, wherein the defect regions of the ART structures are not electrically isolated from rest of the semiconductor device. As a way of example, FIG. 22 diagrammatically illustrates a cross-sectional view of an exemplary photodetector having an ***n-p-n*** junction formed in an ART structure.

Referring to FIG. 22, a non-silicon ART material, which is a germanium (or III-V semiconductor material) in this example, is grown within an opening on a silicon substrate. The opening can be formed from patterning of a dielectric layer deposited on the silicon substrate or can be a STI trench formed in the silicon trench.

The germanium ART structure has a defect region, such as a region comprising dislocation defects, at the bottom. The ***n*** and ***p*** regions can be formed at the dislocation-defect-free top portion of the germanium ART structure. Specifically, an ***n-p-n*** junction can be formed near the top surface of the germanium ART structure. In this example, the bottom defect region in the germanium ART structure is not electrically isolated from the ***n-p-n*** junction or the germanium intrinsic region. Light to be detected is directed from the side of the photodetector.

It is noted that the semiconductor devices, such as the photodectors as discussed above with reference to FIG. 19a through FIG. 22 can be formed in trench structures, such as STI trenches or other types of trenches. The trenches can be formed in a substrate (*e.g.* with dielectric layers on the sidewalls of the trenches when necessary) or can be formed in a dielectric (or insulator) layer over the substrate.

As noted above, teachings of this disclosure have a wide variety of applications. While not limited to ART technology, teachings of this disclosure have many applications within ART technology. For example, examples of the methods disclosed in this disclosure may be used to create photodetectors (e.g., IR, UV) for semiconductor devices. Further, examples of the methods disclosed in this disclosure may be used to create sensors using a ***p-n*** junction or a ***p-i-n*** structure in the sensing region (e.g., IR, UV) for semiconductor devices. A wide variety of devices may incorporate the examples. While not limiting to these devices, the examples may be particularly applicable to mixed signal applications, field effect transistors, quantum tunneling devices, light emitting diodes, laser diodes, resonant tunneling diodes and photovoltaic devices, especially those using ART technology. Further examples can be found in US2008 070355 A1 entitled "Aspect Ratio Trapping for Mixed Signal Applications"; US2008 073667 A1 entitled "Tri-Gate Field-Effect Transistors formed by Aspect Ratio Trapping"; US2008 073641 A1 entitled "Quantum Tunneling Devices and Circuits with Lattice-mismatched Semiconductor Structures"; US2008 093622 A1 entitled "Light-Emitter - Based Devices with Lattice-mismatched Semiconductor Structures"; and US2008 257409 A1 entitled "Photovoltaics on Silicon".

A silicon CMOS device may be processed prior to examples, therefore, examples of devices such as LEDs or photovoltaic devices integrated with CMOS process may be fabricated. Further, structures and/or methods can be used for integration of non-Si channel or active regions for next generation CMOS and for a wide variety of other applications.

The present invention is defined in claim 1. Further embodiments are defined in dependent claims 2-7. Furthermore, for ease of understanding, certain method procedures according to the examples not forming part of the invention claimed may have been delineated as separate procedures; however, these separately delineated procedures should not be construed as necessarily order dependent in their performance. That is, some procedures may be able to be performed in an alternative ordering, simultaneously, etc. In addition, exemplary diagrams illustrate various methods in accordance with embodiments of the present disclosure. Such exemplary method embodiments are described herein using and can be applied to corresponding apparatus embodiments, however, the method embodiments are not intended to be limited thereby.

Although few embodiments of the present invention have been illustrated and described, it would be appreciated by those skilled in the art that changes may be made in these embodiments without departing from the principles of the invention. The foregoing embodiments are therefore to be considered in all respects illustrative rather than limiting on the invention described herein. Scope of the invention is thus indicated by the appended claims rather than by the foregoing description, and all changes which come within the meaning and range of equivalency of the claims are intended to be embraced therein. As used in this disclosure, the term "preferably" is non-exclusive and means "preferably, but not limited to." Terms in the claims should be given their broadest interpretation consistent with the general inventive concept as set forth in this description. For example, the terms "coupled" and "connect" (and derivations thereof) are used to connote both direct and indirect connections/couplings. As another example, "having" and "including", derivatives thereof and similar transitional terms or phrases are used synonymously with "comprising" (i.e., all are considered "open ended" terms) - only the phrases "consisting of" and "consisting essentially of" should be considered as "close ended".

## Claims

1. A sensor, comprising:
- a crystalline substrate (100) having first and second epitaxial crystalline structures (196), wherein the first and second epitaxial crystalline structures (196) are lattice-mismatched to the crystalline substrate (100), and wherein the crystalline substrate (100) is configured with at least one STI trench (109) in the crystalline substrate (100);
- an insulator (101, 103, 120, 124; 154) in the at least one STI trench (109) in the crystalline substrate (100), said insulator (101, 103, 120, 124; 154) comprising at least two openings (184, 186) reaching the crystalline substrate (100), the insulator (101, 103, 120, 124; 154) overlying sides of the at least one STI trench (109) to form the at least two openings (184, 186), wherein the at least two openings (184, 186) are separate from each other, and wherein the first epitaxial crystalline structure (118) is formed in at least a portion of a first (184) of the at least two openings, and the second epitaxial crystalline structure (122) is formed in at least a portion of a second (186) of the at least two openings, and the first and second epitaxial crystalline structures interfacing at a coalesced portion (128) over the insulator (120, 124; 154);
- a sensing region formed at or in the coalesced portion to output electrons generated by light absorption therein; and
- contacts (310, 312, 314, 316) coupled to receive the electrons to obtain an output electric signal.

2. The sensor of claim 1, wherein the first or the second epitaxial crystalline structures (196) is comprised of a semiconductor material.

3. The sensor of claim 1, wherein the sensing region comprises a ***p-n*** junction or a ***p-i-n*** structure.

4. The sensor of claim 1, wherein the sensor is a photodetector pixel of a semiconductor device; the photodetector pixel is a complementary-metal-oxide-semiconductor photodetector; and the photodetector comprises a ***p-n*** junction or a ***p-i-n*** structure and a metal-oxide-semiconductor transistor, wherein the ***p-n*** junction or a ***p-i-n*** structure (192, 190, 194) is formed in the sensing region, and wherein the photodetector is an IR or UV detector.

5. The sensor of claim 1, comprising:
- a *p-i-n* structure (192, 190, 194) formed within the crystalline substrate; and
- an intrinsic region (190) of the *p-i-n* structure is positioned to receive light in the sensing region.

6. The sensor of claim 1, wherein the aspect ratio of the openings is 1 or greater or the aspect ratio of the openings is 0.5 or greater, wherein each opening. (184, 186, 188) is a trench or a hole.

7. The sensor of claim 1, wherein each of said first and second epitaxial crystalline structures (280, 282, 286, 288) comprise an epitaxial lateral overgrowth (ELO) region (196), wherein said ELO region (196) is at least 2 times a width of the opening, at least 5 times the width of the opening or at least 10 times the width of the openings.

## Patentansprüche

1. Sensor, der Folgendes umfasst:
- ein kristallines Substrat (100), das eine erste und eine zweite epitaktische kristalline Struktur (196) besitzt, wobei die erste und die zweite epitaktische kristalline Struktur (196) eine Gitterfehlanpassung in Bezug auf das kristalline Substrat (100) haben und wobei das kristalline Substrat (100) mit wenigstens einem STI-Graben (109) in dem kristallinen Substrat (100) konfiguriert ist;
- einen Isolator (101, 103, 120, 124; 154) in dem wenigstens einen STI-Graben (109) in dem kristallinen Substrat (100), wobei der Isolator (101, 103, 120, 124; 154) wenigstens zwei Öffnungen (184, 186) aufweist, die bis zu dem kristallinen Substrat (100) reichen, wobei der Isolator (101, 103, 120, 124; 154) über dem wenigstens einen STI-Graben (109) liegende Seiten besitzt, um die wenigstens zwei Öffnungen (184, 186) zu bilden, wobei die wenigstens zwei Öffnungen (184, 186) voneinander getrennt sind und wobei die erste epitaktische kristalline Struktur (118) in wenigstens einem Abschnitt einer ersten (184) der wenigstens zwei Öffnungen gebildet ist und die zweite epitaktische kristalline Struktur (122) in wenigstens einem Abschnitt einer zweiten (186) der wenigstens zwei Öffnungen gebildet ist und die erste und die zweite epitaktische kristalline Struktur über dem Isolator (120, 124; 154) eine Grenzfläche mit einem Koaleszenzabschnitt (128) bilden;
- einen Erfassungsbereich, der bei oder in dem Koaleszenzabschnitt gebildet ist, um Elektronen auszugeben, die durch darin stattfindende Lichtabsorption erzeugt werden; und
- Kontakte (310, 312, 314, 316), die so gekoppelt sind, dass sie die Elektronen empfangen, um ein elektrisches Ausgangssignal zu erhalten.

2. Sensor nach Anspruch 1, wobei die erste und die zweite epitaktische kristalline Struktur (196) ein Halbleitermaterial enthalten.

3. Sensor nach Anspruch 1, wobei der Erfassungsbereich einen *p-n*-Übergang oder eine *p-i-n*-Struktur enthält.

4. Sensor nach Anspruch 1, wobei der Sensor ein Photodetektorpixel einer Halbleitervorrichtung ist; das Photodetektorpixel ein Detektor mit komplementärem Metall-Oxid-Halbleiter ist; und der Photodetektor einen *p-n*-Übergang oder eine *p-i-n*-Struktur und einen Metall-Oxid-Halbleiter-Transistor enthält, wobei der *p-n*-Übergang oder eine *p-i-n-*Struktur (192, 190, 194) in dem Erfassungsbereich gebildet ist und wobei der Photodetektor ein IR- oder UV-Detektor ist.

5. Sensor nach Anspruch 1, der Folgendes umfasst:
- eine *p-i-n*-Struktur (192, 190, 194), die in dem kristallinen Substrat gebildet ist; und
- einen intrinsischen Bereich (190) der *p-i-n*-Struktur, der so positioniert ist, dass er Licht in dem Erfassungsbereich empfängt.

6. Sensor nach Anspruch 1, wobei das Schlankheitsverhältnis der Öffnungen gleich 1 oder größer ist oder wobei das Schlankheitsverhältnis der Öffnungen gleich 0,5 oder größer ist, wobei jede Öffnung (184, 186, 188) ein Graben oder ein Loch ist.

7. Sensor nach Anspruch 1, wobei die erste und die zweite epitaktische kristalline Struktur (280, 282, 286, 288) einen epitaktischen seitlichen überwachsenen Bereich (ELO-Bereich) (196) umfasst, wobei der ELO-Bereich (196) wenigstens zweimal so breit, wenigstens fünfmal so breit oder wenigstens zehnmal so breit wie die Öffnungen ist.

## Revendications

1. Capteur comprenant :
- un substrat cristallin (100) comportant des première et deuxième structures cristallines épitaxiales (196), les premières et deuxièmes structures cristallines épitaxiales (196) étant non-appariées par rapport au substrat cristallin (100), et le substrat cristallin (100) étant configuré avec au moins une tranchée STI (109) dans le substrat cristallin (100) ;
- un isolateur (101, 103, 120, 124 ; 154) dans l'au moins une tranchée STI (109) dans la substrat cristallin (100), ledit isolateur (101, 103, 120, 124 ; 154) comprenant au moins deux ouvertures (184, 186) atteignant le substrat cristallin (100), l'isolateur (101, 103, 120, 124 ; 154) recouvrant des côtés de l'au moins une tranchée STI (109) pour former les au moins deux ouvertures (184, 186), les au moins deux ouvertures (184, 186) étant séparées les unes des autres, et la première structure cristalline épitaxiale (118) étant formée dans au moins une partie d'une première (184) des au moins deux ouvertures, et la deuxième structure cristalline épitaxiale (122) étant formée dans au moins une partie d'une deuxième (186) des au moins deux ouvertures, et les première et deuxième structures cristallines épitaxiales formant une interface sur une partie coalescée (128) au-dessus de l'isolateur (120, 124 ; 154) ;
- une région de détection formée sur ou dans la partie coalescée pour émettre des électrons générés par l'absorption de lumière dans celle-ci ; et
- des contacts (310, 312, 314, 316) couplés pour recevoir les électrons afin d'obtenir un signal électrique de sortie.

2. Capteur selon la revendication 1, dans lequel la première ou la deuxième structure cristalline épitaxiale (196) est constituée d'un matériau semi-conducteur.

3. Capteur selon la revendication 1, dans lequel la région de détection comprend une jonction *p-n* ou une structure *p-i-n.*

4. Capteur selon la revendication 1, dans lequel le capteur est un pixel photo-détecteur d'un dispositif semi-conducteur ; le pixel photo-détecteur étant un photo-détecteur semi-conducteur à oxyde métallique complémentaire ; et le photo-détecteur comprend une jonction *p-n* ou une structure *p-i-n* et un transistor semi-conducteur à oxyde métallique, la jonction *p-n* ou une structure *p-i-n* (192, 190, 194) étant formée dans la région de détection, et le photo-détecteur étant un détecteur IR ou UV.

5. Capteur selon la revendication 1, comprenant :
- une structure *p-i-n* (192, 190, 194) formée dans le substrat cristallin ; et
- une région intrinsèque (190) de la structure *p-i-n*, laquelle est positionnée pour recevoir de la lumière dans la région de détection.

6. Capteur selon la revendication 1, dans lequel le rapport de forme des ouvertures est de 1 ou plus, ou le rapport de forme des ouvertures est de 0,5 ou plus, chaque ouverture (184, 186, 188) étant une tranchée ou un trou.

7. Capteur selon la revendication 1, dans lequel chacune desdites premières et deuxièmes structures cristallines épitaxiales (280, 282, 286, 288) comprend une région de surcroissance latérale épitaxiale (ELO) (196), ladite région ELO (196) mesurant au moins deux fois une largeur de l'ouverture, au moins cinq fois la largeur de l'ouverture ou au moins 10 fois la largeur des ouvertures.
